# EUROPEAN PATENT APPLICATION

(11) **EP 4 521 406 A1**
(43) Date of publication of application: **12.03.2025**
(21) Application number: 24805750.7
(22) Date of filing: 06.05.2024
(51) Int. Cl.: G11C 11/22

(54) **FERROELECTRIC MEMORY AND DATA READING METHOD AND DATA WRITING METHOD THEREFOR, AND ELECTRONIC DEVICE**

(30) Priority: 13.06.2023 CN 202310707370
(71) Applicant: CXMT Corporation, Hefei, Anhui 230601 (CN)
(72) Inventor: LIU, Xiang, Hefei, Anhui 230601 (CN)
(74) Representative: Gulde & Partner
(86) International application number: PCT/CN2024/091182
(87) International publication number: WO 2024/255480

(57) **Abstract**

A ferroelectric memory and a data reading method and a data writing method therefor are provided. The ferroelectric memory includes a memory cell array including a plurality of memory cells arranged in an array, a plurality of word lines, and a plurality of bit lines. Each one of the plurality of memory cells stores n-bit data, wherein each one of the plurality of memory cells includes a transistor and 2ⁿ-1 ferroelectric capacitors coupled to the transistor, n being a positive integer greater than 1. Each one of the plurality of word lines is coupled to memory cells arranged in rows of the plurality of memory cells in the memory cell array. Each one of the plurality of bit lines is coupled to memory cells arranged in columns of the plurality of memory cells in the memory cell array. According to the solutions, the multi-state storage of the ferroelectric memory can be achieved and the storage density of the ferroelectric memory can be increased.

## Description

### CROSS-REFERENCE TO RELATED APPLICATION

The present application claims priority to the Chinese Patent Application No. 202310707370.8 entitled "FERROELECTRIC MEMORY AND DATA READING METHOD AND DATA WRITING METHOD THEREFOR", and filed with China National Intellectual Property Administration on June 13, 2023, the content of which is incorporated herein by reference in its entirety.

### TECHNICAL FIELD

The present disclosure relates to the technical field of semiconductors, in particular to a ferroelectric memory and a data reading method and a data writing method therefor, and an electronic apparatus.

### BACKGROUND

With the rapid development of the electronic technology, non-volatile transistor memories can be prepared by using a solution method and are compatible with integrated circuits, and thus are greatly developed. Non-volatile transistor memories include a Not AND (NAND) flash memory, a Not OR (NOR) flash memory, a resistive random access memory, a phase change memory, a magnetoresistive random access memory, a ferroelectric memory, a spin-transfer torque random access memory, and the like. Here, the ferroelectric memory has the highest commercial value due to its advantages of high integration density, good repeatability, and fast response speed. However, the storage density of the ferroelectric memory is low.

### SUMMARY

According to a first aspect of embodiments of the present disclosure, a ferroelectric memory is provided. The ferroelectric memory includes a memory cell array including a plurality of memory cells arranged in an array, a plurality of word lines, and a plurality of bit lines. Each one of the plurality of memory cells stores n -bit data, wherein each one of the plurality of memory cells includes a transistor and 2ⁿ-1 ferroelectric capacitors coupled to the transistor, n being a positive integer greater than 1. Each one of the plurality of word lines is coupled to memory cells arranged in rows of the plurality of memory cells in the memory cell array. Each one of the plurality of bit lines is coupled to memory cells arranged in columns of the plurality of memory cells in the memory cell array.

In some embodiments, each one of the ferroelectric capacitors includes a first electrode plate and a second electrode plate arranged opposite to each other, and a dielectric layer filled between the first electrode plate and the second electrode plate; and the 2ⁿ-1 ferroelectric capacitors are sequentially arranged along a first direction, the 2ⁿ-1 first electrode plates are connected into an integrated structure, the 2ⁿ-1 second electrode plates are connected into an integrated structure, the 2ⁿ-1 dielectric layers are connected into an integrated structure, and the thickness of each one of the dielectric layers is different.

In some embodiments, the thicknesses of the dielectric layers of the 2ⁿ-1 ferroelectric capacitors sequentially increase along the first direction.

In some embodiments, the coercive voltages of the 2ⁿ-1 ferroelectric capacitors are arranged in an arithmetic sequence along the first direction.

In some embodiments, the potentials of the 2ⁿ-1 second electrode plates are the same, the 2ⁿ-1 first electrode plates are connected to one of the source and the drain of the corresponding transistor, the other one of the source and the drain of the transistor is connected to a corresponding one of the plurality of bit lines, and the gate of the transistor is connected to a corresponding one of the plurality of word lines.

In some embodiments, the 2ⁿ-1 second electrode plates are connected into the integrated structure and connected to the same power line, and the potentials of the 2ⁿ-1 second electrode plates are the same.

In some embodiments, each one of the ferroelectric capacitors includes a first electrode plate and a second electrode plate arranged opposite to each other, and a dielectric layer filled between the first electrode plate and the second electrode plate; and the 2ⁿ-1 ferroelectric capacitors are sequentially arranged along a first direction, the 2ⁿ-1 first electrode plates are connected into an integrated structure, the 2ⁿ-1 dielectric layers are connected into an integrated structure, and the 2ⁿ-1 second electrode plates are spaced apart from each other.

In some embodiments, the thicknesses of the 2ⁿ-1 dielectric layers are equal, such that the coercive voltages of the 2ⁿ-1 ferroelectric capacitors are the same.

In some embodiments, the lengths of the 2ⁿ-1 second electrode plates are the same.

In some embodiments, the potentials of the 2ⁿ-1 second electrode plates are different, the 2ⁿ-1 first electrode plates are connected to one of the source and the drain of the corresponding transistor, the other one of the source and the drain of the transistor is connected to a corresponding one of the plurality of bit lines, and the gate of the transistor is connected to a corresponding one of the plurality of word lines.

In some embodiments, the 2ⁿ-1 second electrode plates are connected to different power lines, respectively, and the potentials of the 2ⁿ-1 second electrode plates are different.

In some embodiments, the second electrode plate, the dielectric layer, and the first electrode plate are sequentially stacked to form a planar capacitor.

In some embodiments, the transistor is a thin film transistor.

According to a second aspect of the embodiments of the present disclosure, a data reading method for a ferroelectric memory is provided, which is applied to the ferroelectric memory described above. The data reading method includes charging all the first electrode plates of the 2ⁿ-1 corresponding ferroelectric capacitors to a first voltage by using the bit line and the transistor, the first voltage enabling a polarization orientation of each one of the ferroelectric capacitors to point to the first electrode plate, and positive charges flowing out of the ferroelectric capacitors to the bit line in the case that the polarization orientations of some of the ferroelectric capacitors are flipped; and acquiring the data in the memory cell according to a change in a charge amount of the bit line, where the memory cell stores n-bit data.

In some embodiments, the 2ⁿ-1 ferroelectric capacitors are sequentially arranged along a first direction, and the 2ⁿ-1 first electrode plates form an integrated structure; the 2ⁿ-1 second electrode plates form an integrated structure and are connected to the same power line, and the potentials of the 2ⁿ-1 second electrode plates are the same; and the 2ⁿ-1 dielectric layers form an integrated structure, and the thicknesses of the 2ⁿ-1 dielectric layers are different.

In some embodiments, the 2ⁿ-1 ferroelectric capacitors are sequentially arranged along a first direction, and the 2ⁿ-1 first electrode plates form an integrated structure; the 2ⁿ-1 dielectric layers form an integrated structure; and the 2ⁿ-1 second electrode plates are spaced apart from each other and connected to different power lines, respectively, and the potentials of the 2ⁿ-1 second electrode plates are different.

According to a third aspect of the embodiments of the present disclosure, a data writing method for a ferroelectric memory is provided, which is applied to the ferroelectric memory described above. The data writing method includes charging the first electrode plates of the 2ⁿ-1 corresponding ferroelectric capacitors to a first voltage by using the bit line and the transistor, the first voltage enabling a polarization orientation of each one of the ferroelectric capacitors to point to the first electrode plate, thereby initializing each one of the ferroelectric capacitors; and applying a write voltage to the bit line and the memory cell storing the data, wherein the write voltage has 2ⁿ voltage values, the memory cell stores n-bit data, each one of the voltage values corresponds to one type of data, some of the voltage values enable the polarization orientations of at least some of the ferroelectric capacitors to be flipped, and different voltage values enable the number of the ferroelectric capacitors with flipped polarization orientations different.

In some embodiments, the 2ⁿ-1 ferroelectric capacitors are sequentially arranged along a first direction, and the 2ⁿ-1 first electrode plates form an integrated structure; the 2ⁿ-1 second electrode plates form an integrated structure and are connected to the same power line, and the potentials of the 2ⁿ-1 second electrode plates are the same; and the 2ⁿ-1 dielectric layers form an integrated structure, and the thicknesses of the 2ⁿ-1 dielectric layers are different.

In some embodiments, the 2ⁿ-1 ferroelectric capacitors are sequentially arranged along a first direction, and the 2ⁿ-1 first electrode plates form an integrated structure; the 2ⁿ-1 dielectric layers form an integrated structure; and the 2ⁿ-1 second electrode plates are spaced apart from each other and connected to different power lines, respectively, and the potentials of the 2ⁿ-1 second electrode plates are different.

According to a fourth aspect of the embodiments of the present disclosure, an electronic apparatus is provided. The electronic apparatus includes a processing device; and a memory device electrically connected to the processing device, the memory device including the ferroelectric memory described above.

The data writing method for a ferroelectric memory in the embodiments of the present disclosure is applied to a ferroelectric memory of multi-state storage, and each one of the memory cells of the ferroelectric memory includes a transistor and 2ⁿ-1 ferroelectric capacitors coupled to the transistor, n being a positive integer greater than 1. First electrode plates of the 2ⁿ-1 ferroelectric capacitors are all charged to a first voltage, and the first voltage enables a polarization orientation of each one of the ferroelectric capacitors to point to the first electrode plate, thereby initializing each one of the ferroelectric capacitors. By using different voltage values of a write voltage, each one of the voltage values is enabled to correspond to one type of data, some of the voltage values enable the polarization orientations of at least some of the ferroelectric capacitors to be flipped, and different voltage values enable the number of the ferroelectric capacitors with flipped polarization orientations different, thereby achieving the writing of n-bit data, and increasing the storage density of the ferroelectric memory.

### BRIEF DESCRIPTION OF THE DRAWINGS

FIG. 1 is a schematic diagram of storage 1 of a ferroelectric capacitor in the related art;
FIG. 2 is a schematic diagram of storage 0 of a ferroelectric capacitor in the related art;
FIG. 3 is a schematic structural diagram of a ferroelectric memory according to an embodiment of the present disclosure;
FIG. 4 is a schematic diagram of a polarization state according to an embodiment of the present disclosure;
FIG. 5 is a schematic structural diagram of a ferroelectric capacitor according to an embodiment of the present disclosure;
FIG. 6 is a first storage state of the ferroelectric capacitor of FIG. 5;
FIG. 7 is a second storage state of the ferroelectric capacitor of FIG. 5;
FIG. 8 is a third storage state of the ferroelectric capacitor of FIG. 5;
FIG. 9 is a fourth storage state of the ferroelectric capacitor of FIG. 5;
FIG. 10 is another schematic structural diagram of a ferroelectric capacitor according to an embodiment of the present disclosure;
FIG. 11 is a schematic diagram of connection between a transistor and a ferroelectric capacitor according to an embodiment of the present disclosure;
FIG. 12 is a first storage state of the ferroelectric capacitor of FIG. 10;
FIG. 13 is a second storage state of the ferroelectric capacitor of FIG. 10;
FIG. 14 is a third storage state of the ferroelectric capacitor of FIG. 10;
FIG. 15 is a fourth storage state of the ferroelectric capacitor of FIG. 10;
FIG. 16 is a flowchart of a data reading method for a ferroelectric capacitor according to an embodiment of the present disclosure;
FIG. 17 is a schematic diagram of bit line precharging during data reading of the ferroelectric capacitors of FIG. 5;
FIG. 18 is a diagram of a polarization orientation change of the first storage state of the ferroelectric capacitor of FIG. 5;
FIG. 19 is a diagram of a polarization orientation change of the second storage state of the ferroelectric capacitor of FIG. 5;
FIG. 20 is a diagram of a polarization orientation change of the third storage state of the ferroelectric capacitor of FIG. 5;
FIG. 21 is a diagram of a polarization orientation change of the fourth storage state of the ferroelectric capacitor of FIG. 5;
FIG. 22 is a schematic diagram of bit line precharging during data reading of the ferroelectric capacitors of FIG. 10;
FIG. 23 is a diagram of a polarization orientation change of the first storage state of the ferroelectric capacitor of FIG. 10;
FIG. 24 is a diagram of a polarization orientation change of the second storage state of the ferroelectric capacitor of FIG. 10;
FIG. 25 is a diagram of a polarization orientation change of the third storage state of the ferroelectric capacitor of FIG. 10;
FIG. 26 is a diagram of a polarization orientation change of the third storage state of the ferroelectric capacitor of FIG. 10;
FIG. 27 is a flowchart of a data writing method for a ferroelectric capacitor according to an embodiment of the present disclosure;
FIG. 28 is a schematic diagram of bit line precharging during data writing of the ferroelectric capacitors of FIG. 5;
FIG. 29 is a diagram of a polarization orientation change of the ferroelectric capacitor of FIG. 5 in the case that a write voltage is a first preset value;
FIG. 30 is a diagram of a polarization orientation change of the ferroelectric capacitor of FIG. 5 in the case that a write voltage is a second preset value;
FIG. 31 is a diagram of a polarization orientation change of the ferroelectric capacitor of FIG. 5 in the case that a write voltage is a third preset value;
FIG. 32 is a diagram of a polarization orientation change of the ferroelectric capacitor of FIG. 5 in the case that a write voltage is a fourth preset value;
FIG. 33 is a schematic diagram of bit line precharging during data writing of the ferroelectric capacitors of FIG. 10;
FIG. 34 is a diagram of a polarization orientation change of the ferroelectric capacitor of FIG. 10 in the case that a write voltage is a first preset value;
FIG. 35 is a diagram of a polarization orientation change of the ferroelectric capacitor of FIG. 10 in the case that a write voltage is a second preset value;
FIG. 36 is a diagram of a polarization orientation change of the ferroelectric capacitor of FIG. 10 in the case that a write voltage is a third preset value;
FIG. 37 is a diagram of a polarization orientation change of the ferroelectric capacitor of FIG. 10 in the case that a write voltage is a fourth preset value; and
FIG. 38 is a schematic structural diagram of an electronic apparatus illustrated according to some embodiments of the present disclosure.

### DETAILED DESCRIPTION

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. Advantages and features of the present disclosure will become apparent from the following description and claims. It should be noted that the drawings are all in a very simplified form and not to precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between a top surface and a bottom surface of a continuous structure, or a layer may be located between any pair of horizontal planes at the top surface and the bottom surface of the continuous structure. A layer may extend horizontally, vertically, and/or along inclined surfaces. A layer may include a plurality of sub-layers.

It should be noted that unless conflicting, the technical solutions described in the embodiments of the present disclosure may be arbitrarily combined.

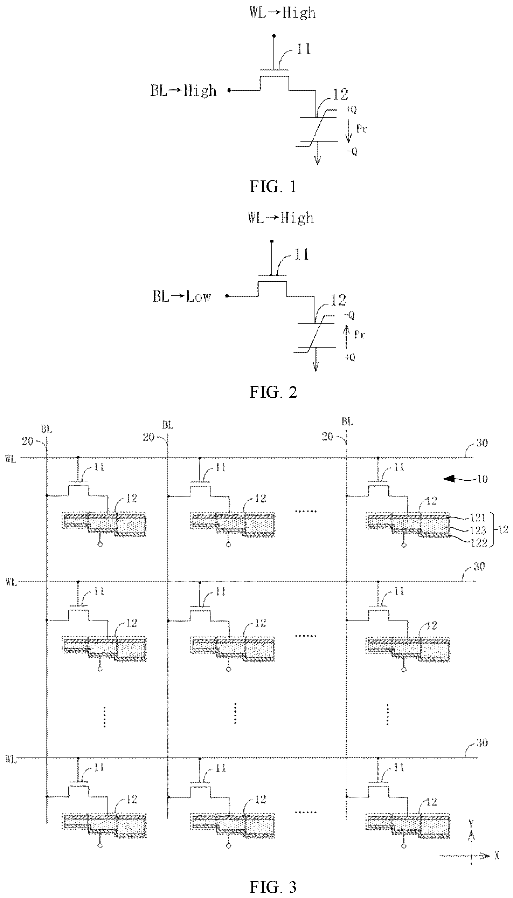

The ferroelectric memory in the related art has a problem of low storage density, and the inventor researches and discovers that the reason is that: a ferroelectric memory includes a plurality of memory cells, each one of which is generally of a 1T1C (ferroelectric cell) structure, including a transistor and a ferroelectric capacitor. Referring to FIGS. 1 and 2, the ferroelectric capacitor has 2 polarization orientations, i.e., two stable states, which are stored in the form of "0" or "1", and each one of the plurality of memory cells can store only one-bit data, resulting in a low storage density.

Therefore, the embodiments of the present disclosure provide a ferroelectric memory, which includes a plurality of memory cells, wherein each one of the plurality of memory cells includes a transistor and 2ⁿ-1 ferroelectric capacitors coupled to the transistor, n being a positive integer greater than 1, such that n-bit data can be stored. Here, 2ⁿ storage states can be determined by using the polarization orientations of the 2ⁿ-1 ferroelectric capacitors, and each one of the storage states corresponds to one type of data, such that the 2ⁿ-1 ferroelectric capacitors store n-bit data, thereby achieving the multi-state storage of the ferroelectric memory, and increasing the storage density of the ferroelectric memory.

To make the above objectives, features, and advantages of the embodiments of the present disclosure more clearly and easily understandable, the technical solutions in the embodiments of the present disclosure will be clearly and completely described below with reference to the drawings in the embodiments of the present disclosure. It is obvious that the described embodiments are only part of the embodiments of the present disclosure rather than all of the embodiments. Based on the embodiments of the present disclosure, all other embodiments obtained by those skilled in the art without creative work shall fall within the protection scope of the present disclosure.

Referring to FIG. 3, the embodiments of the present disclosure provide a semiconductor structure. The semiconductor structure includes a memory cell array, and a plurality of word lines 30 and a plurality of bit lines 20 electrically connected to the memory cell array. The memory cell array is configured to store data, and includes a plurality of memory cells 10; the plurality of memory cells 10 are arranged in an array and spaced apart from each other, that is, the plurality of memory cells 10 are arranged in multiple rows and multiple columns, and a row direction (an X direction shown in FIG. 3) and a column direction (a Y direction shown in FIG. 3) are perpendicular to each other, thereby increasing the storage density of the memory cell array.

The plurality of word lines 30 are spaced apart from each other, the plurality of bit lines 20 are spaced apart from each other, and the extending direction of the plurality of word lines 30 intersects with the extending direction of the plurality of bit lines 20, for example, being perpendicular. Each one of the plurality of word lines 30 is coupled to memory cells 10 arranged in rows of the plurality of memory cells in the memory cell array, i.e., each one of the plurality of word lines 30 is coupled to a row of the memory cells 10. Each one of the plurality of bit lines 20 is coupled to memory cells 10 arranged in columns of the plurality of memory cells in the memory cell array, i.e., each one of the plurality of bit lines 20 is coupled to a column of the memory cells 10.

With continued reference to FIG. 3, each one of the plurality of memory cells 10 stores n-bit data, and each one of the plurality of memory cells 10 includes a transistor 11 and 2ⁿ-1 ferroelectric capacitors 12 coupled to the transistor 11, n being a positive integer greater than 1. In the case that the transistor 11 is turned on, the memory cell 10 performs data writing or data reading.

Each one of the ferroelectric capacitors 12 includes a first electrode plate 121 and a second electrode plate 122 arranged opposite to each other, and a dielectric layer 123 filled between the first electrode plate 121 and the second electrode plate 122. Two sides of the dielectric layer 123 are provided with the first electrode plate 121 and the second electrode plate 122, respectively, the material of the dielectric layer 123 being a ferroelectric material; that is, the second electrode plate 122, the dielectric layer 123, and the first electrode plate 121 are sequentially stacked to form a planar capacitor. As shown in FIG. 3, the second electrode plate 122 is a lower electrode plate of the ferroelectric capacitor 12, and the first electrode plate 121 is an upper electrode plate of the ferroelectric capacitor 12.

Since each one of the ferroelectric capacitors 12 of the 2ⁿ-1 ferroelectric capacitors 12 can be polarized, 2ⁿ storage states can be determined according to the polarization orientations of the 2ⁿ-1 ferroelectric capacitors 12, each one of the storage states corresponding to one type of data, such that the 2ⁿ-1 ferroelectric capacitors 12 store n-bit data. The storage state is the number of the ferroelectric capacitors 12 with the polarization orientations being a preset direction among the 2ⁿ-1 ferroelectric capacitors 12.

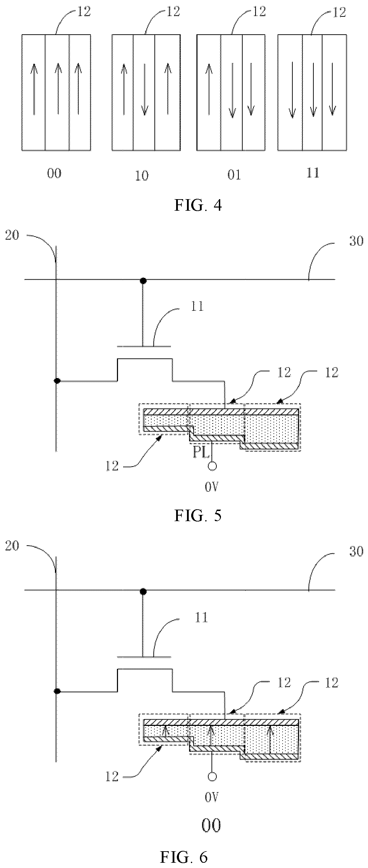

Exemplarily, referring to FIG. 4, in the case that n is 2, the transistor 11 in each one of the plurality of memory cells 10 is correspondingly connected to 3 ferroelectric capacitors 12, and the three ferroelectric capacitors 12 can determine 4 storage states to store 2-bit data. The ferroelectric capacitor 12 with the polarization orientation pointing to a third direction may be 3, 2, 1, or 0 in number, and accordingly, the three ferroelectric capacitors 12 correspond to data 00, 10, 01, and 11, respectively. As shown in FIG. 4, the polarization orientation pointing to the third direction refers to that the polarization orientation is upward, that is, the polarization orientation points to the upper electrode plate (the first electrode plate 121) of the ferroelectric capacitor 12. In addition, in the case that n is 3, the transistor 11 in each one of the plurality of memory cells 10 is correspondingly connected to 7 ferroelectric capacitors 12, and the three ferroelectric capacitors 12 can determine 8 storage states to store 3-bit data.

It will be appreciated that, in the case that there are 3 ferroelectric capacitors 12 with the polarization orientations pointing to the third direction, that is, the three ferroelectric capacitors 12 are all polarized toward the third direction (upward), the three ferroelectric capacitors 12 correspond to 00, that is, the memory cell stores 00. In the case that there are 2 ferroelectric capacitors with the polarization orientations pointing to the third direction, that is, any two ferroelectric capacitors 12 of the three ferroelectric capacitors 12 are polarized toward the third direction (upward), and the remaining ferroelectric capacitor 12 is polarized toward an opposite direction to the third direction (downward), the three ferroelectric capacitors 12 correspond to 10, that is, the memory cell stores 10. In the case that there is 1 ferroelectric capacitor with the polarization orientation pointing to the third direction, that is, any one ferroelectric capacitor 12 of the three ferroelectric capacitors 12 is polarized toward the third direction (upward), and the remaining two ferroelectric capacitors 12 are polarized toward an opposite direction to the third direction (downward), the three ferroelectric capacitors 12 correspond to 01, that is, the memory cell stores 01. In the case that there is 0 ferroelectric capacitor 12 with the polarization orientation pointing to the third direction, that is, the three ferroelectric capacitors 12 are all polarized toward an opposite direction to the third direction (downward), the three ferroelectric capacitors 12 correspond to 11, that is, the memory cell stores 11. The three ferroelectric capacitors 12 have 4 different polarization methods and thus have 4 storage states to store 2-bit data.

Referring to FIGS. 3 and 5, in some possible embodiments, the 2ⁿ-1 ferroelectric capacitors 12 are sequentially arranged along a first direction, wherein the 2ⁿ-1 first electrode plates 121 form an integrated structure, the 2ⁿ-1 second electrode plates 122 form an integrated structure, the 2ⁿ-1 dielectric layers 123 form an integrated structure, and the thicknesses of the 2ⁿ-1 dielectric layers 123 are different, such that the coercive voltages of the 2ⁿ-1 ferroelectric capacitors 12 are different, thereby resulting in n storage states.

It will be appreciated that, due to different thicknesses of the dielectric layers 123, the second electrode plates 122 are spaced apart from each other along a thickness direction of the dielectric layers 123, and adjacent second electrode plates 122 are connected to form a whole through a connecting electrode plate. The dielectric layers 123 are made of the same material. The larger the thickness of the dielectric layer 123 is, the larger the coercive voltage of the ferroelectric capacitor 12 is, and the larger the applied voltage required for flipping the polarization orientation thereof is.

In some embodiments, the thicknesses of the dielectric layers 123 of the 2ⁿ-1 ferroelectric capacitors 12 sequentially increase along the first direction; that is, the 2ⁿ-1 second electrode plates 122 are connected into a step shape, the second electrode plates 122 form a step surface, and two ends of the connecting electrode plate are connected to two adjacent second electrode plates 122, respectively. According to the arrangement, the coercive voltages of the 2ⁿ-1 ferroelectric capacitors 12 are sequentially increased along the first direction, and the leakage current between the adjacent ferroelectric capacitors 12 is reduced.

The coercive voltages of the 2ⁿ-1 ferroelectric capacitors 12 are arranged in an arithmetic sequence along the first direction, that is, the coercive voltages of the 2ⁿ-1 ferroelectric capacitors 12 are increased in a gradient manner along the first direction. According to the arrangement, while the leakage current is reduced, the coercive voltage of each one of the ferroelectric capacitors 12 can also have a certain degree of discrimination, thereby preventing the polarization orientation of the ferroelectric capacitor 12 from being flipped erroneously. In an example, the memory cell 10 includes 3 ferroelectric capacitors 12, the coercive voltages of the 3 ferroelectric capacitors 12 may be 0.5 V, 1.5 V, and 2.5 V sequentially.

With continued reference to FIGS. 3 and 5, the 2ⁿ-1 second electrode plates 122 are of the same potential, e.g., being connected to a zero potential, that is, the applied voltage of each one of the ferroelectric capacitors 12 is the same. In the case that the applied voltage is greater than the coercive voltage, the polarization orientation of the ferroelectric capacitor 12 is flipped. Here, the 2ⁿ-1 first electrode plates 121 are connected to one of the source and the drain of the corresponding transistor 11, and the other one of the source and the drain of the transistor 11 is connected to a corresponding one of the plurality of bit lines 20, so as to write data from the bit line 20 to the ferroelectric capacitor 12 or read data in the ferroelectric capacitor 12 to the bit line 20. The gate of the transistor 11 is connected to a corresponding one of the plurality of word lines 30, and the word line 30 controls the turning on or off of the transistor 11.

As shown in FIGS. 3 and 5, the 2ⁿ-1 first electrode plates 121 are integrally formed and connected to the bit line 20 through the transistor 11, and the 2ⁿ-1 second electrode plates 122 are integrally formed and connected to the same power line (PL), such that the potentials of the 2ⁿ-1 second electrode plates 122 are the same. The voltage difference between the first electrode plate 121 and the second electrode plate 122 arranged opposite to each other is the applied voltage of the ferroelectric capacitor 12. The applied voltages of the 2ⁿ-1 ferroelectric capacitors 12 are the same, but the coercive voltages of the 2ⁿ-1 ferroelectric capacitors 12 are different. According to the magnitude relationship between the applied voltages and the coercive voltages, the polarization orientations of the 2ⁿ-1 ferroelectric capacitors 12 are flipped or remain unchanged, thereby writing or reading data.

Referring to FIGS. 6 to 9, the 2ⁿ-1 ferroelectric capacitors 12 have 2ⁿ storage states, i.e., 2ⁿ different polarization states, and each one of the storage states may correspond to one type of data to store n-bit data. For example, in the case that n is 2, 3 ferroelectric capacitors 12 have four storage states, corresponding to 00, 10, 01, and 11, respectively.

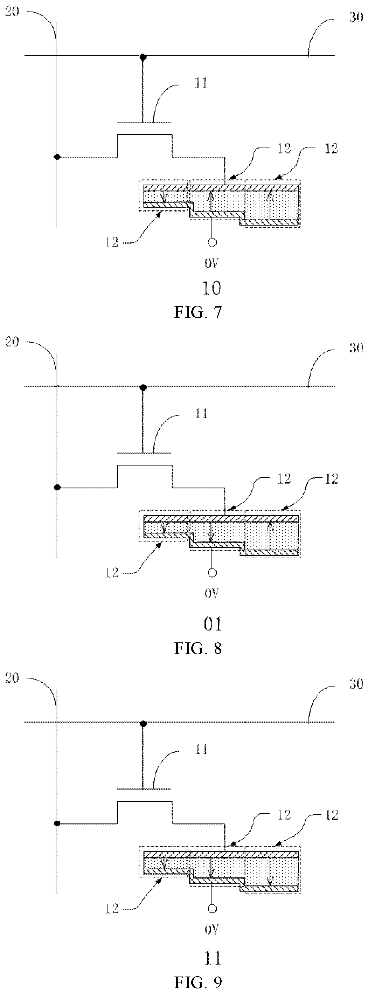

As shown in FIG. 6, the polarization orientations of all the ferroelectric capacitors 12 among the 3 ferroelectric capacitors 12 all point to the first electrode plates 121, and the polarization state corresponds to 00. As shown in FIG. 7, the polarization orientations of 2 ferroelectric capacitors 12 among the 3 ferroelectric capacitors 12 point to the first electrode plates 121, and the polarization state corresponds to 10. As shown in FIG. 8, the polarization orientation of 1 ferroelectric capacitor 12 among the 3 ferroelectric capacitors 12 points to the first electrode plate 121, and the polarization state corresponds to 01. As shown in FIG. 9, the polarization orientations of all the ferroelectric capacitors 12 among the 3 ferroelectric capacitors 12 point to the second electrode plates 122, and the polarization state corresponds to 11.

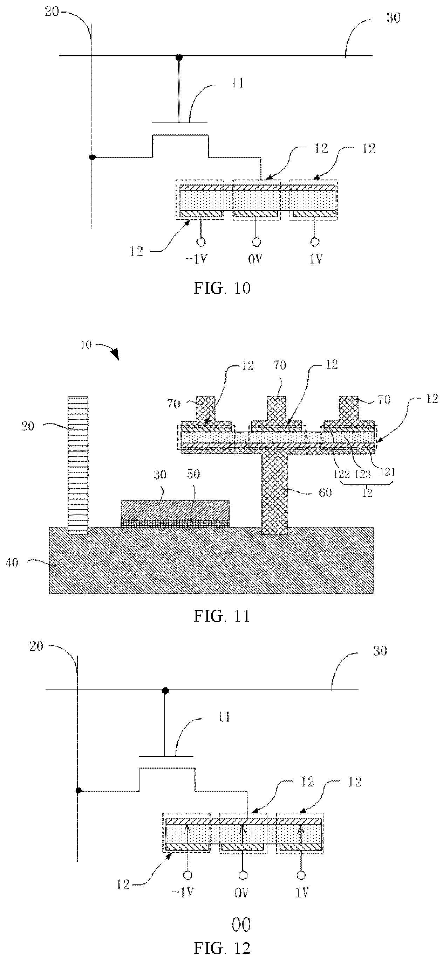

Referring to FIGS. 10 and 11, in other possible embodiments, the 2ⁿ-1 ferroelectric capacitors 12 are sequentially arranged along a first direction, the 2ⁿ-1 first electrode plates 121 are connected into an integrated structure, the 2ⁿ-1 dielectric layers 123 are connected into an integrated structure, and the 2ⁿ-1 second electrode plates 122 are spaced apart from each other, such that the applied voltage of each one of the ferroelectric capacitors 12 is different (for example, arranged in an arithmetic sequence) and the applied voltage of each one of the ferroelectric capacitors 12 remains unchanged, thereby resulting in n storage states. In an example, the memory cell 10 includes 3 ferroelectric capacitors 12, the applied voltages of the 3 ferroelectric capacitors 12 may be -1 V, 0 V, and 1 V, respectively.

The thicknesses of the 2ⁿ-1 dielectric layers 123 are equal, such that the coercive voltages of the 2ⁿ-1 ferroelectric capacitors 12 are the same, facilitating manufacturing. Due to the coercive voltage of each one of the ferroelectric capacitors 12, each one of the ferroelectric capacitors 12 does not need to be discriminated, and writing data into the memory cell 10 or reading data from the memory cell 10 can be controlled by adjusting the applied voltage of each one of the ferroelectric capacitors 12. The lengths of the 2ⁿ-1 second electrode plates 122 are the same, such that each one of the ferroelectric capacitors 12 is the same.

It will be appreciated that, to achieve the connection between the ferroelectric capacitors 12, a connecting electrode plate is connected between two adjacent first electrode plates 121 along the first direction, and a connection layer is connected between two adjacent dielectric layers 123, thereby achieving that the first electrode plates 121 are integrally formed, the dielectric layers 123 are integrally formed, and the second electrode plates 122 are spaced apart from each other.

To achieve data writing or data reading, as shown in FIG. 11, the potentials of the 2ⁿ-1 second electrode plates 122 are different, the 2ⁿ-1 first electrode plates 121 are connected to one of the source and the drain of the corresponding transistor 11, the other one of the source and the drain of the transistor 11 is connected to a corresponding one of the plurality of bit lines 20, and the gate of the transistor 11 is connected to a corresponding one of the plurality of word lines 30.

As shown in FIG. 10, the 2ⁿ-1 first electrode plates 121 are integrally formed and connected to the bit line 20 through the transistor 11, and the 2ⁿ-1 second electrode plates 122 are connected to different power lines, respectively, such that the potentials of the 2ⁿ-1 second electrode plates 122 are different. The voltage difference between the first electrode plate 121 and the second electrode plate 122 arranged opposite to each other is the applied voltage of the ferroelectric capacitor 12. The applied voltages of the 2ⁿ-1 ferroelectric capacitors 12 are different, and according to the magnitude relationship between the applied voltages and the coercive voltages, the polarization orientations of the 2ⁿ-1 ferroelectric capacitors 12 are flipped or remain unchanged, thereby writing or reading data.

Referring to FIGS. 10 to 15, the 2ⁿ-1 ferroelectric capacitors 12 have 2ⁿ storage states, i.e., 2ⁿ different polarization states, and each one of the storage states may correspond to one type of data to store n-bit data. For example, in the case that n is 2, 3 ferroelectric capacitors 12 have four storage states, corresponding to 00, 10, 01, and 11, respectively.

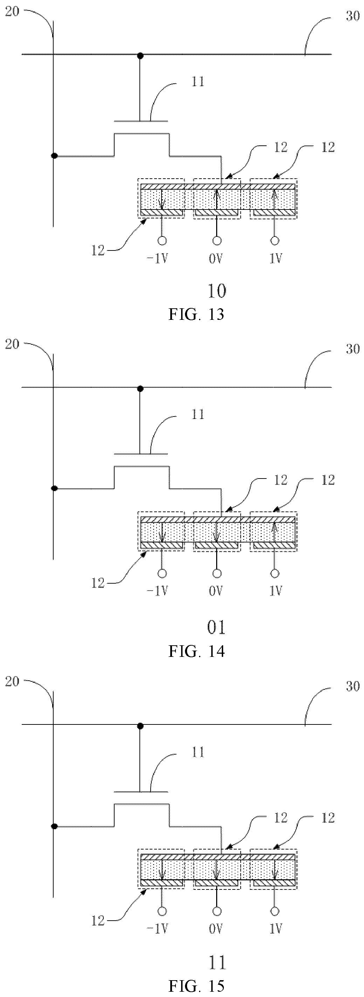

As shown in FIG. 12, the polarization orientations of all the ferroelectric capacitors 12 among the 3 ferroelectric capacitors 12 all point to the first electrode plates 121, and the polarization state corresponds to 00. As shown in FIG. 13, the polarization orientations of 2 ferroelectric capacitors 12 among the 3 ferroelectric capacitors 12 point to the first electrode plates 121, and the polarization state corresponds to 10. As shown in FIG. 14, the polarization orientation of 1 ferroelectric capacitor 12 among the 3 ferroelectric capacitors 12 points to the first electrode plate 121, and the polarization state corresponds to 01. As shown in FIG. 15, the polarization orientations of all the ferroelectric capacitors 12 among the 3 ferroelectric capacitors 12 point to the second electrode plates 122, and the polarization state corresponds to 11.

The type and structure of the transistor 11 in the embodiments of the present disclosure are not limited, and the transistor 11 may be a thin film transistor (TFT), which facilitates 3D stacking. The transistor 11 may also be a planar transistor or the like, and may be compatible with a dynamic random access memory (DRAM) process.

Exemplarily, as shown in FIG. 11, the transistor 11 includes an active region arranged within a substrate 40, a gate dielectric layer 50 located above the active region, and a gate located above the gate dielectric layer 50, with the word line 30 serving as the gate. The first electrode plates 121 of the ferroelectric capacitors 12 are connected to form a whole and connected to the active region through a plug 60, and the second electrode plates 122 of the ferroelectric capacitors 12 are connected to conductive lines 70, respectively, and connected to a peripheral circuit through the conductive lines 70, such that different voltage values are provided to the second electrode plates 122 of the ferroelectric capacitors 12, thereby enabling the second electrode plates 122 of the ferroelectric capacitors 12 to be at different potentials.

In summary, the ferroelectric memory provided in the embodiments of the present disclosure includes a memory cell array, a plurality of word lines 30, and a plurality of bit lines 20; the memory cell array includes a plurality of memory cells 10 arranged in an array, each one of the plurality of word lines 30 is coupled to memory cells 10 arranged in rows of the plurality of memory cells in the memory cell array, and each one of the plurality of bit lines 20 is coupled to memory cells 10 arranged in columns of the plurality of memory cells in the memory cell array. Each one of the plurality of memory cells 10 includes a transistor 11 and 2ⁿ-1 ferroelectric capacitors 12 coupled to the transistor 11, n being a positive integer greater than 1, such that n-bit data can be stored. Here, 2ⁿ storage states can be determined by using the polarization orientations of the 2ⁿ-1 ferroelectric capacitors 12, and each one of the storage states corresponds to one type of data, such that the 2ⁿ-1 ferroelectric capacitors 12 store n-bit data, thereby achieving the multi-state storage of the ferroelectric memory, and increasing the storage density of the ferroelectric memory.

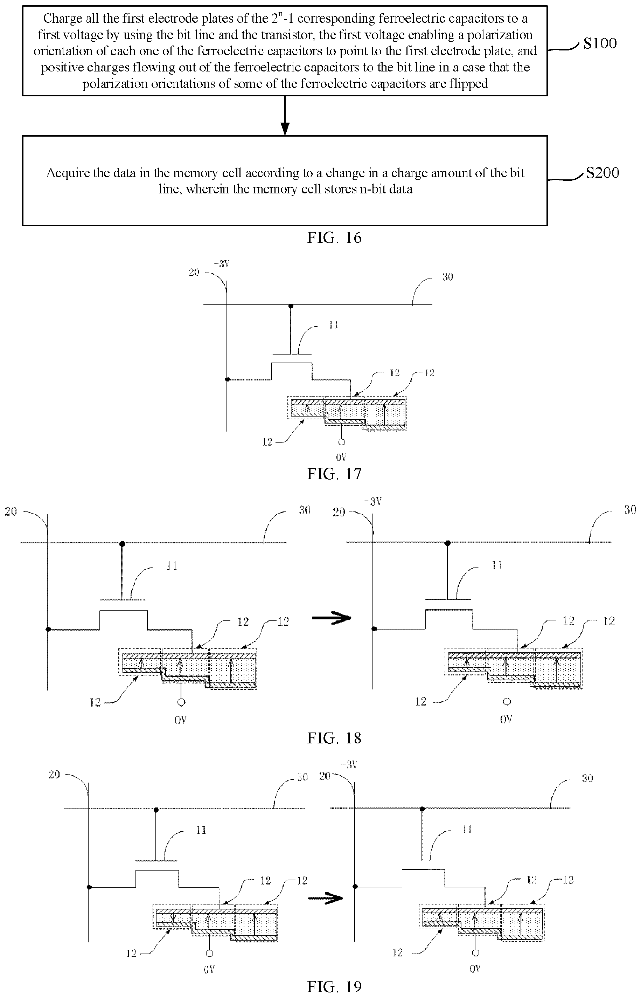

The embodiments of the present disclosure further provide a data reading method for a ferroelectric memory, applied to the ferroelectric memory described above, for which reference is made to FIGS. 3, 5, 10, and 11, and the specific structure of the ferroelectric memory refers to the above embodiments, which is not reiterated herein. Referring to FIG. 16, the data reading method includes the following steps:

In step S100, the first electrode plates of the 2ⁿ-1 corresponding ferroelectric capacitors are all charged to a first voltage by using the bit line and the transistor; the first voltage enables a polarization orientation of each one of the ferroelectric capacitors to point to the first electrode plate, and positive charges flow out of the ferroelectric capacitor to the bit line in the case that the polarization orientation of some of the ferroelectric capacitor is flipped.

The voltage on the bit line 20 is precharged to the first voltage, and the word line 30 and the transistor 11 are turned on, such that the first electrode plates 121 of the 2ⁿ-1 ferroelectric capacitors 12 corresponding to the transistor 11 are all charged to the first voltage, that is, the first electrode plates 121 of the ferroelectric capacitors 12 are all of the first voltage. The first voltage is a low voltage, and the absolute value of the potential difference between the first electrode plate 121 and the second electrode plate 122 is greater than the coercive voltage of each one of the ferroelectric capacitors 12, such that the polarization orientation of each one of the ferroelectric capacitors 12 points to the first electrode plate 121.

Before the first electrode plates 121 of the 2ⁿ-1 ferroelectric capacitors 12 are charged, the polarization orientations of the 2ⁿ-1 ferroelectric capacitors 12 may have various cases, such that the 2ⁿ-1 ferroelectric capacitors 12 are in different storage states to store data. After the first electrode plates 121 of the 2ⁿ-1 ferroelectric capacitors 12 are charged, the polarization orientations of the ferroelectric capacitors 12 all point to the first electrode plates 121. In the case that the polarization orientation of each one of the ferroelectric capacitors 12 remains unchanged, no charge flows from the ferroelectric capacitor 12 to the bit line 20. In the case that the polarization orientation of any one of the ferroelectric capacitors 12 is flipped, charges flow in the flipping process of the ferroelectric capacitor 12; positive charges flow from the ferroelectric capacitor 12 to the bit line 20, and the charge amount of the positive charges is positively correlated with the number of the flipped ferroelectric capacitors 12.

In step S200, data in the memory cell is acquired according to a change in the charge amount of the bit line. The memory cell stores n-bit data.

Data in the memory cell 10 can be acquired according to a change in the charge amount of the bit line 20, and 2ⁿ storage states can be determined based on the polarization orientations of the 2ⁿ-1 ferroelectric capacitors 12; each one of the storage states corresponds to one type of data, and the memory cell 10 can store n-bit data.

In some embodiments, as shown in FIG. 5, the 2ⁿ-1 ferroelectric capacitors 12 are sequentially arranged along a first direction, the 2ⁿ-1 first electrode plates 121 form an integrated structure, the 2ⁿ-1 second electrode plates 122 form an integrated structure, the 2ⁿ-1 dielectric layers 123 form an integrated structure, and the thicknesses of the 2ⁿ-1 dielectric layers 123 are different. To facilitate the description of the data reading process for the ferroelectric memory, n takes a value of 2, that is, each one of the plurality of memory cells 10 has 3 ferroelectric capacitors 12. In this case, the coercive voltages of the 3 ferroelectric capacitors 12 are 0.5 V, 1 V, and 1.5 V sequentially, and the external voltages of the second electrode plates 122 of the 3 ferroelectric capacitors 12 are all 0 V.

Referring to FIG. 17, the voltage of the bit line 20 is precharged to a first voltage, and the absolute value of the difference between the first voltage and each one of the external voltages is greater than the coercive voltages. For example, the first voltage may be -3 V. The word line 30 and the transistor 11 are turned on, and the potentials of the first electrode plates 121 of the 3 ferroelectric capacitors 12 are all the first voltage, i.e., -3 V. The potential differences between the first electrode plates 121 and the second electrode plates 122 are all greater than the coercive voltages, and the potentials of the first electrode plates 121 are lower, such that the polarization orientations of the 3 ferroelectric capacitors 12 all point to the first electrode plates 121.

Referring to FIG. 18, before the word line 30 and the transistor 11 are turned on, in the case that the polarization orientations of the 3 ferroelectric capacitors 12 all point to the first electrode plates 121, the 3 ferroelectric capacitors 12 store 00. After the word line 30 and the transistor 11 are turned on, the polarization orientations of the 3 ferroelectric capacitors 12 remain unchanged, and no charge flows.

Referring to FIG. 19, before the word line 30 and the transistor 11 are turned on, in the case that the polarization orientations of 2 ferroelectric capacitors 12 both point to the first electrode plates 121, and the polarization orientation of 1 ferroelectric capacitor 12 points to the second electrode plate 122, for example, the polarization orientation of a first ferroelectric capacitor 12 points to the second electrode plate 122, the 3 ferroelectric capacitors 12 store 10. After the word line 30 and the transistor 11 are turned on, the polarization orientation of 1 ferroelectric capacitor 12 is flipped, and the first electrode plate 121 of the ferroelectric capacitor 12 is changed from positive charges to negative charges, which is equivalent to 2 units of positive charges flowing to the bit line 20. The polarization orientations of the remaining 2 ferroelectric capacitors 12 remain unchanged and do not contribute to the charge flow, which is equivalent to 2 units of positive charges flowing to the bit line 20 in total.

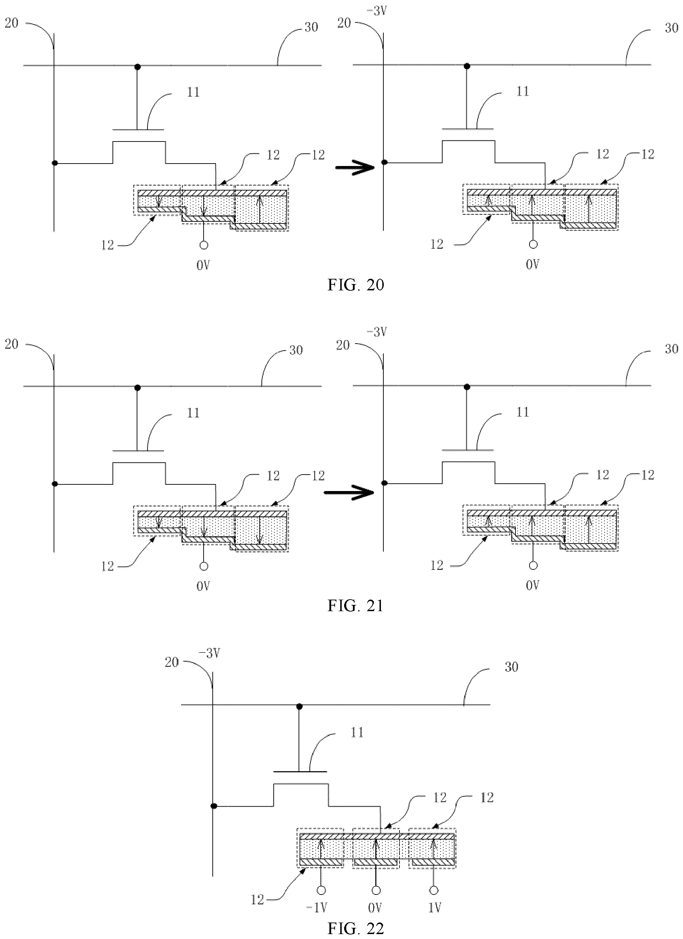

Referring to FIG. 20, before the word line 30 and the transistor 11 are turned on, in the case that the polarization orientation of 1 ferroelectric capacitor 12 points to the first electrode plate 121, the polarization orientations of 2 ferroelectric capacitors 12 both point to the second electrode plates 122, for example, the polarization orientation of a third ferroelectric capacitor 12 points to the first electrode plate 121, the 3 ferroelectric capacitors 12 store 01. After the word line 30 and the transistor 11 are turned on, the polarization orientations of 2 ferroelectric capacitors 12 are flipped, and the first electrode plates 121 of the two ferroelectric capacitors 12 are changed from positive charges to negative charges, which is equivalent to 4 units of positive charges flowing to the bit line 20. The polarization orientation of the remaining 1 ferroelectric capacitor 12 remains unchanged and does not contribute to the charge flow, which is equivalent to 4 units of positive charges flowing to the bit line 20 in total.

Referring to FIG. 21, before the word line 30 and the transistor 11 are turned on, in the case that the polarization orientations of the 3 ferroelectric capacitors 12 all point to the second electrode plates 122, the 3 ferroelectric capacitors 12 store 11. After the word line 30 and the transistor 11 are turned on, the polarization orientations of the 3 ferroelectric capacitors 12 are all flipped, which is equivalent to 6 units of positive charges flowing to the bit line 20 in total.

The positive charges flowing out to the bit line 20 change the voltage or current on the bit line 20, and corresponding data can be read out according to a change in the charge amount on the bit line 20; four different storage states, namely 2-bit data, can be read out. In the case that the data reading is completed, the data needs to be rewritten back to the ferroelectric capacitor 12.

In other embodiments, the 2ⁿ-1 ferroelectric capacitors 12 are sequentially arranged along a first direction, the 2ⁿ-1 first electrode plates 121 are connected into an integrated structure, the 2ⁿ-1 dielectric layers 123 are connected into an integrated structure, and the 2ⁿ-1 second electrode plates 122 are spaced apart from each other. To facilitate the description of the data reading process for the ferroelectric memory, n takes a value of 2, that is, each one of the plurality of memory cells 10 has 3 ferroelectric capacitors 12. In this case, the coercive voltages of the 3 ferroelectric capacitors 12 are all 1.5 V, and the external voltages of the second electrode plates 122 of the 3 ferroelectric capacitors 12 are -1 V, 0 V, and 1 V, respectively.

Referring to FIG. 22, the voltage of the bit line 20 is precharged to a first voltage, and the absolute value of the potential difference between the first voltage and each one of the external voltages is greater than the coercive voltages. For example, the first voltage may be -3 V. The word line 30 and the transistor 11 are turned on, and the potentials of the first electrode plates 121 of the 3 ferroelectric capacitors 12 are all the first voltage, i.e., -3 V. The potential differences between the first electrode plates 121 and the second electrode plates 122 are all greater than the coercive voltages, and the potentials of the first electrode plates 121 are lower, such that the polarization orientations of the 3 ferroelectric capacitors 12 all point to the first electrode plates 121.

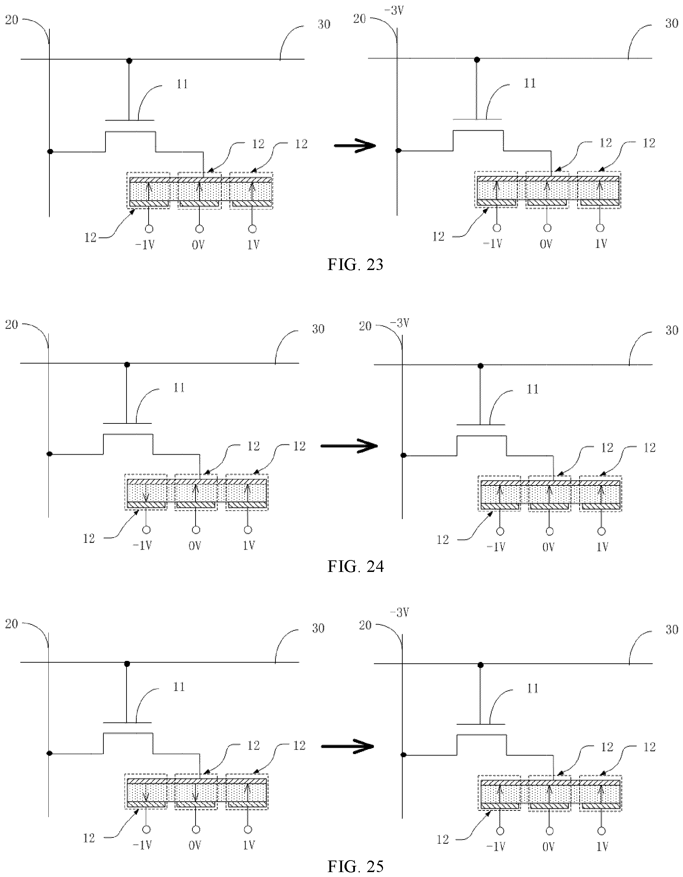

Referring to FIG. 23, before the word line 30 and the transistor 11 are turned on, in the case that the polarization orientations of the 3 ferroelectric capacitors 12 all point to the first electrode plates 121, the 3 ferroelectric capacitors 12 store 00. After the word line 30 and the transistor 11 are turned on, the polarization orientations of the 3 ferroelectric capacitors 12 remain unchanged, and no charge flows.

Referring to FIG. 24, before the word line 30 and the transistor 11 are turned on, in the case that the polarization orientations of 2 ferroelectric capacitors 12 both point to the first electrode plates 121, and the polarization orientation of 1 ferroelectric capacitor 12 points to the second electrode plate 122, for example, the polarization orientation of a first ferroelectric capacitor 12 points to the second electrode plate 122, the 3 ferroelectric capacitors 12 store 10. After the word line 30 and the transistor 11 are turned on, the polarization orientation of 1 ferroelectric capacitor 12 is flipped, and the first electrode plate 121 of the ferroelectric capacitor 12 is changed from positive charges to negative charges, which is equivalent to 2 units of positive charges flowing to the bit line 20. The polarization orientations of the remaining 2 ferroelectric capacitors 12 remain unchanged and do not contribute to the charge flow, which is equivalent to 2 units of positive charges flowing to the bit line 20 in total.

Referring to FIG. 25, before the word line 30 and the transistor 11 are turned on, in the case that the polarization orientation of 1 ferroelectric capacitor 12 points to the first electrode plate 121, the polarization orientations of 2 ferroelectric capacitors 12 both point to the second electrode plates 122, for example, the polarization orientation of a third ferroelectric capacitor 12 points to the first electrode plate 121, the 3 ferroelectric capacitors 12 store 01. After the word line 30 and the transistor 11 are turned on, the polarization orientations of 2 ferroelectric capacitors 12 are flipped, and the first electrode plates 121 of the two ferroelectric capacitors 12 are changed from positive charges to negative charges, which is equivalent to 4 units of positive charges flowing to the bit line 20. The polarization orientation of the remaining 1 ferroelectric capacitor 12 remains unchanged and does not contribute to the charge flow, which is equivalent to 4 units of positive charges flowing to the bit line 20 in total.

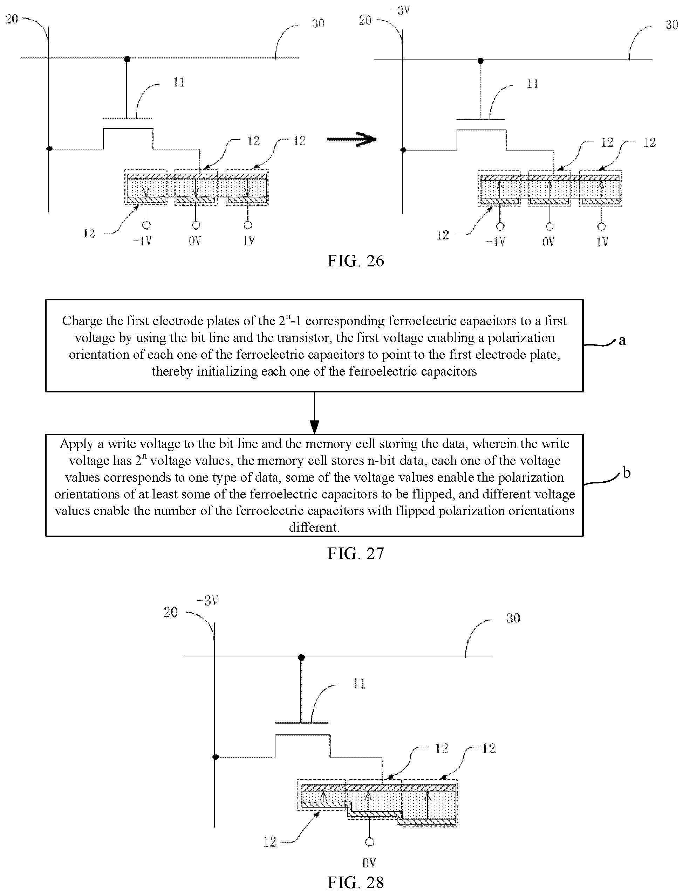

Referring to FIG. 26, before the word line 30 and the transistor 11 are turned on, in the case that the polarization orientations of the 3 ferroelectric capacitors 12 all point to the second electrode plates 122, the 3 ferroelectric capacitors 12 store 11. After the word line 30 and the transistor 11 are turned on, the polarization orientations of the 3 ferroelectric capacitors 12 are all flipped, which is equivalent to 6 units of positive charges flowing to the bit line 20 in total.

The positive charges flowing out to the bit line 20 change the voltage or current on the bit line 20, and corresponding data can be read out according to a change in the charge amount on the bit line 20; four different storage states, namely 2-bit data, can be read out. In the case that the data reading is completed, the data needs to be rewritten back to the ferroelectric capacitor 12.

In summary, the data reading method for a ferroelectric memory in the embodiments of the present disclosure is applied to a ferroelectric memory of multi-state storage, and each one of the plurality of memory cells 10 of the ferroelectric memory includes a transistor 11 and 2ⁿ-1 ferroelectric capacitors 12 coupled to the transistor 11, n being a positive integer greater than 1. The first electrode plates 121 of the 2ⁿ-1 ferroelectric capacitors 12 are all charged to a first voltage, the first voltage enables the polarization orientation of each one of the ferroelectric capacitors 12 to point to the first electrode plate 121, positive charges can flow out to the bit line 20 in the case that the polarization orientation of the ferroelectric capacitor 12 is flipped, and data in the memory cell 10 can be acquired according to a change in the charge amount of the bit line 20, thereby achieving the reading of n-bit data, and increasing the storage density of the ferroelectric memory.

The embodiments of the present disclosure further provide a data writing method for a ferroelectric memory, applied to the ferroelectric memory described above, for which reference is made to FIGS. 3, 5, 30, and 31, and the specific structure of the ferroelectric memory refers to the above embodiments, which is not reiterated herein. Referring to FIG. 27, the data writing method may include the following steps:

In step a, the first electrode plates of the 2ⁿ-1 corresponding ferroelectric capacitors are charged to a first voltage by using the bit line and the transistor, and the first voltage enables the polarization orientation of each one of the ferroelectric capacitors to point to the first electrode plate, thereby initializing each one of the ferroelectric capacitors.

The voltage on the bit line 20 is precharged to the first voltage, and the word line 30 and the transistor 11 are turned on, such that the first electrode plates 121 of the 2ⁿ-1 ferroelectric capacitors 12 corresponding to the transistor 11 are all charged to the first voltage, that is, the potentials of the first electrode plates 121 of the ferroelectric capacitors 12 are all the first voltage. The first voltage is a low voltage, and the absolute value of the potential difference between the first electrode plate 121 and the second electrode plate 122 is greater than the coercive voltage of each one of the ferroelectric capacitors 12, such that the polarization orientation of each one of the ferroelectric capacitors 12 points to the first electrode plate 121, thereby completing the initialization of the 2ⁿ-1 ferroelectric capacitors 12.

In step b, a write voltage is applied to the bit line, and the memory cell stores data. The write voltage has 2ⁿ voltage values, the memory cell stores n-bit data, each one of the voltage values corresponds to one type of data, some of the voltage values enable the polarization orientations of at least some of the ferroelectric capacitors to be flipped, and different voltage values enable the number of the ferroelectric capacitors with flipped polarization orientations different.

A write voltage is applied to the bit line 20, and data is written to the 2ⁿ-1 corresponding ferroelectric capacitors 12 through the transistor 11, such that the memory cell 10 stores the data. The write voltage has 2ⁿ voltage values, and each one of the voltage values corresponds to one storage state of the 2ⁿ-1 ferroelectric capacitors 12 and corresponds to one type of data. The storage state refers to the polarization state of the 2ⁿ-1 ferroelectric capacitors 12, and may specifically be the number of the ferroelectric capacitors 12 with the polarization orientations pointing to the second electrode plates 122 (or the first electrode plates 121) among the 2ⁿ-1 ferroelectric capacitors 12.

It will be appreciated that, one voltage value of the 2ⁿ voltage values of the write voltage enables the polarization orientations of the 2ⁿ-1 ferroelectric capacitors 12 to remain unchanged, that is, the number of the ferroelectric capacitors 12 with flipped polarization orientations is 0, and another voltage value enables the polarization orientations of the 2ⁿ-1 ferroelectric capacitors 12 to be flipped, that is, the number of the ferroelectric capacitors 12 with flipped polarization orientations is 2ⁿ-1. The remaining voltage values enable the polarization orientations of part of the ferroelectric capacitors 12 among the 2ⁿ-1 ferroelectric capacitors 12 to be flipped, and the number of the flipped ferroelectric capacitors 12 corresponding to each one of the voltage values of the remaining voltage values is different and is an integer from 0 to 2ⁿ-1 sequentially. Different voltage values enable different numbers of the ferroelectric capacitors 12 with flipped polarization orientations, such that each one of the voltage values corresponds to different data.

For example, in the case that n is 2, the write voltage has 4 voltage values, which are a first preset value, a second preset value, a third preset value, and a fourth preset value sequentially. In the case that the voltage value of the write voltage is the first preset value, the polarization orientation of 0 ferroelectric capacitor 12 is flipped. In the case that the voltage value of the write voltage is the second preset value, the polarization orientation of 1 ferroelectric capacitor 12 is flipped. In the case that the voltage value of the write voltage is the third preset value, the polarization orientations of 2 ferroelectric capacitors 12 are flipped. In the case that the voltage value of the write voltage is the fourth preset value, the polarization orientations of 3 ferroelectric capacitors 12 are flipped.

In some embodiments, the 2ⁿ-1 ferroelectric capacitors 12 are sequentially arranged along a first direction, the 2ⁿ-1 first electrode plates 121 form an integrated structure, the 2ⁿ-1 second electrode plates 122 form an integrated structure, the 2ⁿ-1 dielectric layers 123 form an integrated structure, and the thicknesses of the 2ⁿ-1 dielectric layers 123 are different. To facilitate the description of the data writing process for the ferroelectric memory, n takes a value of 2, that is, each one of the plurality of memory cells 10 has 3 ferroelectric capacitors 12. In this case, the coercive voltages of the 3 ferroelectric capacitors 12 are 0.5 V, 1 V, and 1.5 V sequentially, and the voltage values of the external voltage of the second electrode plates 122 of the 3 ferroelectric capacitors 12 are all 0 V.

Referring to FIG. 28, the voltage of the bit line 20 is precharged to a first voltage, and the absolute value of the difference between the first voltage and each one of the external voltages is greater than the coercive voltages. For example, the first voltage may be -3 V. The word line 30 and the transistor 11 are turned on, and the potentials of the first electrode plates 121 of the 3 ferroelectric capacitors 12 are all the first voltage, i.e., -3 V. The potential differences between the first electrode plates 121 and the second electrode plates 122 are all greater than the coercive voltages, and the potentials of the first electrode plates 121 are lower, such that the polarization orientations of the 3 ferroelectric capacitors 12 all point to the first electrode plates.

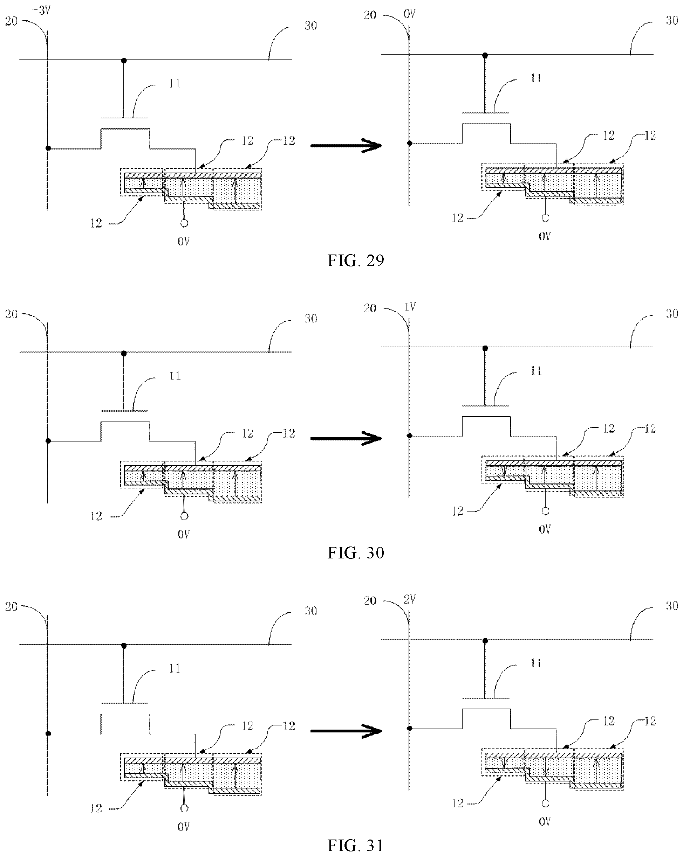

Referring to FIG. 29, a write voltage is applied to the bit line 20. In the case that the voltage value of the write voltage is the first preset value, the potentials of the first electrode plates 121 of the 3 ferroelectric capacitors 12 are all the first preset value, and the potentials of the second electrode plates 122 of the 3 ferroelectric capacitors 12 are all the voltage values of the external voltage. The absolute value of the difference between the first preset value of each one of the ferroelectric capacitors and the voltage value of the external voltage is less than the coercive voltage of the ferroelectric capacitor 12. The polarization orientations of the 3 ferroelectric capacitors 12 all point to the first electrode plates 121, and the polarization orientations remain unchanged, such that data 00 is stored. For example, the first preset value is 0 V, and the difference between the first preset value and the voltage value 0 V of the external voltage is less than the coercive voltage of each one of the ferroelectric capacitors 12.

Referring to FIG. 30, a write voltage is applied to the bit line 20. In the case that the voltage value of the write voltage is the second preset value, the potentials of the first electrode plates 121 of the 3 ferroelectric capacitors 12 are all the second preset value, and the potentials of the second electrode plates 122 of the 3 ferroelectric capacitors 12 are all the voltage values of the external voltage. The absolute value of the difference between the second preset value of only 1 ferroelectric capacitor 12 among the 3 ferroelectric capacitors 12 and the voltage value of the external voltage is greater than the coercive voltage of the ferroelectric capacitor 12; the polarization orientation of the ferroelectric capacitor 12 is flipped, and the polarization orientations of the remaining 2 ferroelectric capacitors 12 remain unchanged, such that data 10 is stored. For example, the second preset value is 1 V, and in this case, the polarization orientation of the ferroelectric capacitor 12 with the coercive voltage of 0.5 V is flipped, and the polarization orientations of the remaining two ferroelectric capacitors 12 remain unchanged.

Referring to FIG. 31, a write voltage is applied to the bit line 20. In the case that the voltage value of the write voltage is the third preset value, the potentials of the first electrode plates 121 of the 3 ferroelectric capacitors 12 are all the third preset value, and the potentials of the second electrode plates 122 of the 3 ferroelectric capacitors 12 are all the voltage values of the external voltage. The absolute values of the differences between the third preset value of 2 ferroelectric capacitors 12 among the 3 ferroelectric capacitors 12 and the voltage values of the external voltage are greater than the coercive voltages of the ferroelectric capacitors 12; the polarization orientations of the ferroelectric capacitors 12 are flipped, and the polarization orientation of the remaining 1 ferroelectric capacitor 12 remains unchanged, such that data 01 is stored. For example, the third preset value is 2 V, and in this case, the polarization orientations of the ferroelectric capacitors 12 with the coercive voltages of 0.5 V and 1 V are flipped, and the polarization orientation of the remaining one ferroelectric capacitor 12 remains unchanged.

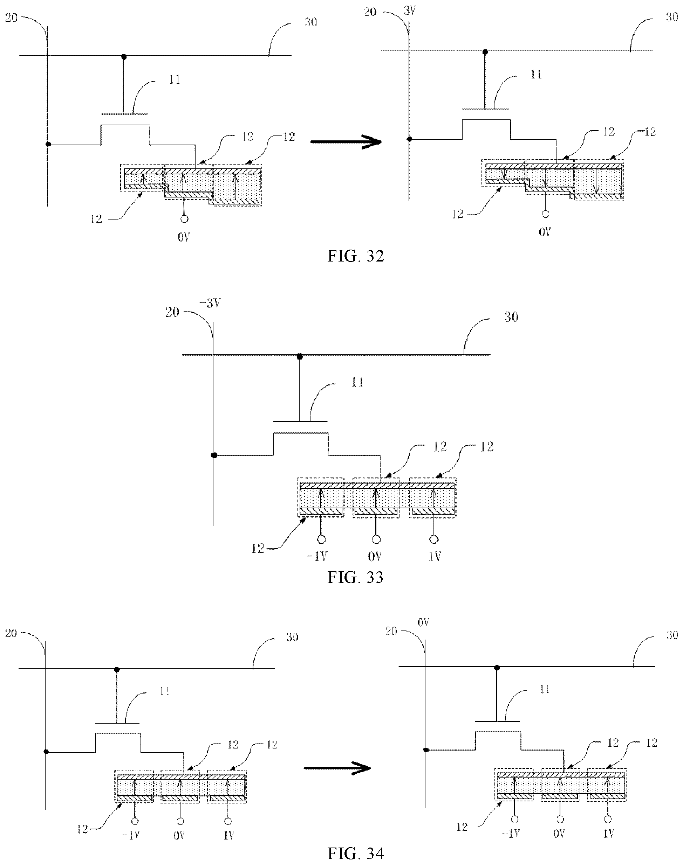

Referring to FIG. 32, a write voltage is applied to the bit line 20. In the case that the voltage value of the write voltage is the fourth preset value, the potentials of the first electrode plates 121 of the 3 ferroelectric capacitors 12 are all the fourth preset value, and the potentials of the second electrode plates 122 of the 3 ferroelectric capacitors 12 are all the voltage values of the external voltage. The absolute values of the differences between the fourth preset value of the 3 ferroelectric capacitors 12 and the voltage values of the external voltage are all greater than the coercive voltages, and the polarization orientations of the 3 ferroelectric capacitors 12 are flipped, such that data 11 is stored. For example, the third preset value is 3 V, and in this case, the polarization orientations of the ferroelectric capacitors 12 with the coercive voltages of 0.5 V, 1 V, and, 1.5 V are flipped.

In other embodiments, the 2ⁿ-1 ferroelectric capacitors 12 are sequentially arranged along a first direction, the 2ⁿ-1 first electrode plates 121 are connected into an integrated structure, the 2ⁿ-1 dielectric layers 123 are connected into an integrated structure, and the 2ⁿ-1 second electrode plates 122 are spaced apart from each other. To facilitate the description of the data writing process for the ferroelectric memory, n takes a value of 2, that is, each one of the plurality of memory cells 10 has 3 ferroelectric capacitors 12. In this case, the coercive voltages of the 3 ferroelectric capacitors 12 are all 1.5 V, and the external voltages of the second electrode plates 122 of the 3 ferroelectric capacitors 12 are -1 V, 0 V, and 1 V, respectively.

Referring to FIG. 33, the voltage of the bit line 20 is precharged to a first voltage, and the absolute value of the potential difference between the first voltage and each one of the external voltages is greater than the coercive voltages. For example, the first voltage may be -3 V. The word line 30 and the transistor 11 are turned on, and the potentials of the first electrode plates 121 of the 3 ferroelectric capacitors 12 are all the first voltage, i.e., -3 V. The potential differences between the first electrode plates 121 and the second electrode plates 122 are all greater than the coercive voltages, and the potentials of the first electrode plates 121 are lower, such that the polarization orientations of the 3 ferroelectric capacitors 12 all point to the first electrode plates 121.

Referring to FIG. 34, a write voltage is applied to the bit line 20. In the case that the voltage value of the write voltage is the first preset value, the potentials of the first electrode plates 121 of the 3 ferroelectric capacitors 12 are all the first preset value, and the potentials of the second electrode plates 122 of the 3 ferroelectric capacitors 12 are all the voltage values of the external voltage, the voltage values of the external voltage being different. The absolute value of the difference between the first preset value of each one of the ferroelectric capacitors and the voltage value of the external voltage is less than 1.5 V, i.e., less than the coercive voltage of the ferroelectric capacitor 12. The polarization orientations of the 3 ferroelectric capacitors 12 all point to the first electrode plates 121, and the polarization orientations remain unchanged, such that data 00 is stored. For example, the first preset value is 0 V, and the absolute values of the differences between the first preset value and -1 V, 0 V, and 1 V are all less than 1.5 V.

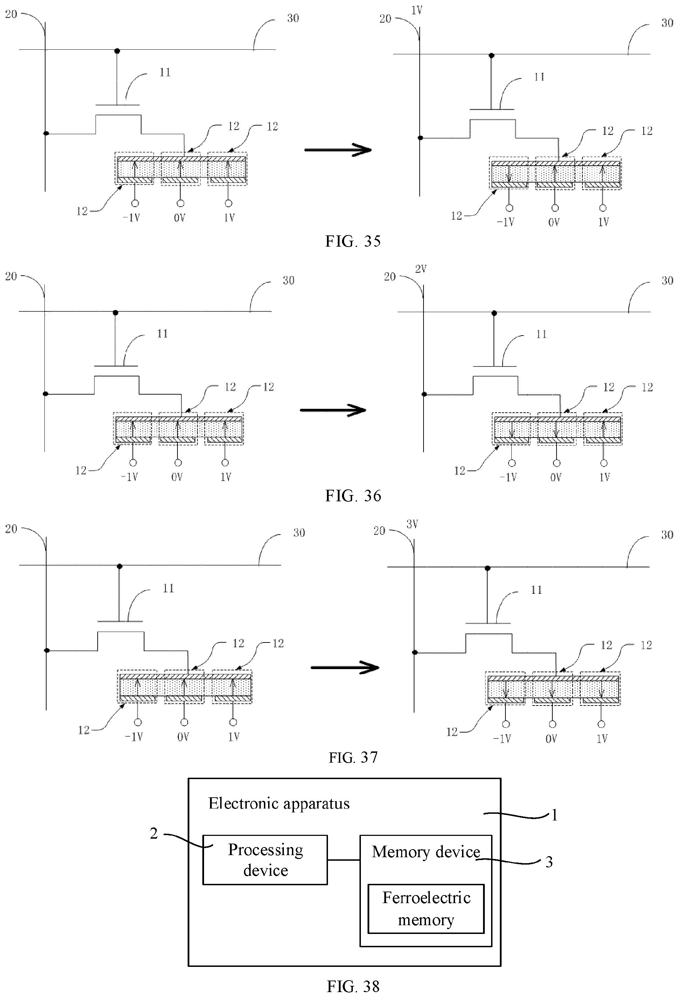

Referring to FIG. 35, a write voltage is applied to the bit line 20. In the case that the voltage value of the write voltage is the second preset value, the potentials of the first electrode plates 121 of the 3 ferroelectric capacitors 12 are all the second preset value, and the potentials of the second electrode plates 122 of the 3 ferroelectric capacitors 12 are all the voltage values of the external voltage. The absolute value of the difference between the second preset value of only 1 ferroelectric capacitor 12 among the 3 ferroelectric capacitors 12 and the voltage value of the external voltage is greater than the coercive voltage of the ferroelectric capacitor 12; the polarization orientation of the ferroelectric capacitor 12 is flipped, and the polarization orientations of the remaining 2 ferroelectric capacitors 12 remain unchanged, such that data 10 is stored. For example, the second preset value is 1 V, and in this case, the polarization orientation of the ferroelectric capacitor 12 with the voltage value of the external voltage being -1 V is flipped, and the polarization orientations of the remaining two ferroelectric capacitors 12 remain unchanged.

Referring to FIG. 36, a write voltage is applied to the bit line 20. In the case that the voltage value of the write voltage is the third preset value, the potentials of the first electrode plates 121 of the 3 ferroelectric capacitors 12 are all the third preset value, and the potentials of the second electrode plates 122 of the 3 ferroelectric capacitors 12 are all the voltage values of the external voltage. The absolute values of the differences between the third preset value of 2 ferroelectric capacitors 12 among the 3 ferroelectric capacitors 12 and the voltage values of the external voltage are greater than the coercive voltages of the ferroelectric capacitors 12; the polarization orientations of the ferroelectric capacitors 12 are flipped, and the polarization orientation of the remaining 1 ferroelectric capacitor 12 remains unchanged, such that data 01 is stored. For example, the third preset value is 2 V, and in this case, the polarization orientations of the ferroelectric capacitors 12 with the voltage values of the external voltage being -1 V and 0 V are both flipped, and the polarization orientation of the ferroelectric capacitor 12 with the voltage value of the external voltage being 1 V remains unchanged.

Referring to FIG. 37, a write voltage is applied to the bit line 20. In the case that the voltage value of the write voltage is the fourth preset value, the potentials of the first electrode plates 121 of the 3 ferroelectric capacitors 12 are all the fourth preset value, and the potentials of the second electrode plates 122 of the 3 ferroelectric capacitors 12 are all the voltage values of the external voltage. The absolute values of the differences between the fourth preset value of the 3 ferroelectric capacitors 12 and the voltage values of the external voltage are all greater than the coercive voltages, and the polarization orientations of the 3 ferroelectric capacitors 12 are flipped, such that data 11 is stored. For example, the third preset value is 3 V, and in this case, the polarization orientations of the ferroelectric capacitors 12 with the voltage values of the external voltage being -1 V, 0 V, and, 1 V are flipped.

In summary, the data writing method for a ferroelectric memory in the embodiments of the present disclosure is applied to a ferroelectric memory of multi-state storage, and each one of the plurality of memory cells 10 of the ferroelectric memory includes a transistor 11 and 2ⁿ-1 ferroelectric capacitors 12 coupled to the transistor 11, n being a positive integer greater than 1. First electrode plates 121 of the 2ⁿ-1 ferroelectric capacitors 12 are all charged to a first voltage, and the first voltage enables the polarization orientation of each one of the ferroelectric capacitors 12 to point to the first electrode plate 121, thereby initializing each one of the ferroelectric capacitors 12. By using different voltage values of a write voltage, each one of the voltage values is enabled to correspond to one type of data, some of the voltage values enable the polarization orientations of at least some of the ferroelectric capacitors 12 to be flipped, and different voltage values enable the number of the ferroelectric capacitors 12 with flipped polarization orientations different, thereby achieving the writing of n-bit data, and increasing the storage density of the ferroelectric memory.

FIG. 38 is a schematic structural diagram of an electronic apparatus illustrated according to some embodiments of the present disclosure. Referring to FIG. 38, the embodiments of the present disclosure further provide an electronic apparatus 1, including a processing device 2 and a memory device 3 electrically connected to the processing device 2, the memory device 3 including the ferroelectric memory illustrated in any one of the above embodiments. The electronic apparatus 1 may be a terminal apparatus, such as a mobile phone, a tablet computer, and a smart band, or may be a personal computer (PC), a server, a workstation, etc. The storage function in the electronic apparatus 1 may be implemented by the memory device 3 of a ferroelectric random access memory (FRAM).

The embodiments and implementations in the specification are all described in a progressive manner, and each embodiment focuses on differences from other embodiments, and portions that are the same and similar between the embodiments may be referred to each other. The reference term "an embodiment", "some embodiments", "schematic embodiments", "an example", "a specific example", or "some examples" means that a specific feature, structure, material, or characteristic described in connection with the embodiment or example is included in at least one embodiment or example of the present disclosure. In this specification, the schematic description of the above terms does not necessarily refer to the same embodiment or example. Moreover, the specific feature, structure, material, or characteristic described may be combined in a suitable manner in any one or more embodiments or examples.

Finally, it should be noted that: the above embodiments are merely used for illustrating the technical solutions of the present disclosure, rather than being limited; although the present disclosure has been described in detail with reference to the above embodiments, those of ordinary skill in the art will appreciate that: the technical solutions described in the foregoing embodiments may still be modified, or some or all of the technical features may be equivalently replaced; and these modifications or replacements do not cause the essence of the corresponding technical solutions to depart from the scope of the technical solutions of the embodiments of the present disclosure.

## Claims

1. A ferroelectric memory, comprising:
a memory cell array, the memory cell array comprising a plurality of memory cells (10) arranged in an array, each one of the plurality of memory cells (10) storing n-bit data, wherein each one of the plurality of memory cells (10) comprises a transistor (11) and 2ⁿ-1 ferroelectric capacitors (12) coupled to the transistor, the n being a positive integer greater than 1;
a plurality of word lines (30), each one of the plurality of word lines (30) being coupled to memory cells (10) arranged in rows of the plurality of memory cells in the memory cell array; and
a plurality of bit lines (20), each one of the plurality of bit lines (20) being coupled to memory cells (10) arranged in columns of the plurality of memory cells in the memory cell array.

2. The ferroelectric memory according to claim 1, wherein each one of the ferroelectric capacitors (12) comprises a first electrode plate (121) and a second electrode plate (122) arranged opposite to each other, and a dielectric layer (123) filled between the first electrode plate (121) and the second electrode plate (122); and wherein
the 2ⁿ-1 ferroelectric capacitors are sequentially arranged along a first direction, the 2ⁿ-1 first electrode plates (121) are connected into an integrated structure, the 2ⁿ-1 second electrode plates (122) are connected into an integrated structure, the 2ⁿ-1 dielectric layers (123) are connected into an integrated structure, and a thickness of each one of the dielectric layers (123) is different.

3. The ferroelectric memory according to claim 2, wherein the thicknesses of the dielectric layers (123) of the 2ⁿ-1 ferroelectric capacitors (12) sequentially increase along the first direction.

4. The ferroelectric memory according to claim 2 or 3, wherein coercive voltages of the 2ⁿ-1 ferroelectric capacitors (12) are arranged in an arithmetic sequence along the first direction.

5. The ferroelectric memory according to any one of claims 2 to 4, wherein potentials of the 2ⁿ-1 second electrode plates (122) are the same, the 2ⁿ-1 first electrode plates (121) are connected to one of a source and a drain of the corresponding transistor (11), the other one of the source and the drain of the transistor (11) is connected to a corresponding one of the plurality of bit lines (20), and a gate of the transistor (11) is connected to a corresponding one of the plurality of word lines (30).

6. The ferroelectric memory according to any one of claims 2 to 5, wherein the 2ⁿ-1 second electrode plates (122) are connected into the integrated structure and connected to a same power line (PL), and the potentials of the 2ⁿ-1 second electrode plates (122) are the same.

7. The ferroelectric memory according to claim 1, wherein each one of the ferroelectric capacitors (12) comprises a first electrode plate (121) and a second electrode plate (122) arranged opposite to each other, and a dielectric layer (123) filled between the first electrode plate (121) and the second electrode plate (122); and wherein
the 2ⁿ-1 ferroelectric capacitors (12) are sequentially arranged along a first direction, the 2ⁿ-1 first electrode plates (121) are connected into an integrated structure, the 2ⁿ-1 dielectric layers (123) are connected into an integrated structure, and the 2ⁿ-1 second electrode plates (122) are spaced apart from each other.

8. The ferroelectric memory according to claim 7, wherein thicknesses of the 2ⁿ-1 dielectric layers (123) are equal, such that coercive voltages of the 2ⁿ-1 ferroelectric capacitors (12) are the same.

9. The ferroelectric memory according to claim 7 or 8, wherein lengths of the 2ⁿ-1 second electrode plates (122) are the same.

10. The ferroelectric memory according to any one of claims 7 to 9, wherein potentials of the 2ⁿ-1 second electrode plates (122) are different, the 2ⁿ-1 first electrode plates (121) are connected to one of a source and a drain of the corresponding transistor (11), the other one of the source and the drain of the transistor (11) is connected to a corresponding one of the plurality of bit lines (20), and a gate of the transistor (11) is connected to a corresponding one of the plurality of word lines (30).

11. The ferroelectric memory according to any one of claims 7 to 10, wherein the 2ⁿ-1 second electrode plates (122) are connected to different power lines, respectively, and the potentials of the 2ⁿ-1 second electrode plates (122) are different.

12. The ferroelectric memory according to any one of claims 2 to 11, wherein the second electrode plate (122), the dielectric layer (123), and the first electrode plate (121) are sequentially stacked to form a planar capacitor.

13. The ferroelectric memory according to any one of claims 1 to 12, wherein the transistor (11) is a thin film transistor.

14. A data reading method for a ferroelectric memory, applied to the ferroelectric memory according to any one of claims 1 to 13, the data reading method comprising:
charging all the first electrode plates (121) of the 2ⁿ-1 corresponding ferroelectric capacitors (12) to a first voltage by using the bit line (20) and the transistor (11), the first voltage enabling a polarization orientation of each one of the ferroelectric capacitors (12) to point to the first electrode plate (121), and positive charges flowing out of the ferroelectric capacitors (12) to the bit line (20) in a case that the polarization orientations of some of the ferroelectric capacitors (12) are flipped; and
acquiring the data in the memory cell (10) according to a change in a charge amount of the bit line (20), wherein the memory cell stores n-bit data.

15. The data reading method for a ferroelectric memory according to claim 14, wherein the 2ⁿ-1 ferroelectric capacitors (12) are sequentially arranged along a first direction, and
the 2ⁿ-1 first electrode plates (121) form an integrated structure;
the 2ⁿ-1 second electrode plates (122) form an integrated structure and are connected to a same power line (PL), and potentials of the 2ⁿ-1 second electrode plates (122) are the same; and
the 2ⁿ-1 dielectric layers (123) form an integrated structure, and thicknesses of the 2ⁿ-1 dielectric layers (123) are different.

16. The data reading method for a ferroelectric memory according to claim 14, wherein the 2ⁿ-1 ferroelectric capacitors (12) are sequentially arranged along a first direction, and
the 2ⁿ-1 first electrode plates (121) form an integrated structure;
the 2ⁿ-1 dielectric layers (123) form an integrated structure; and
the 2ⁿ-1 second electrode plates (122) are spaced apart from each other and connected to different power lines, respectively, and potentials of the 2ⁿ-1 second electrode plates (122) are different.

17. A data writing method for a ferroelectric memory, applied to the ferroelectric memory according to any one of claims 1 to 13, the data writing method comprising:
charging the first electrode plates (121) of the 2ⁿ-1 corresponding ferroelectric capacitors (12) to a first voltage by using the bit line (20) and the transistor (11), the first voltage enabling a polarization orientation of each one of the ferroelectric capacitors (12) to point to the first electrode plate (121), thereby initializing each one of the ferroelectric capacitors (12); and
applying a write voltage to the bit line (20) and the memory cell (10) storing data, wherein the write voltage has 2ⁿ voltage values, the memory cell (10) stores n-bit data, each one of the voltage values corresponds to one type of data, some of the voltage values enable the polarization orientations of at least some of the ferroelectric capacitors to be flipped, and different voltage values enable the number of the ferroelectric capacitors with flipped polarization orientations different.

18. The data writing method for a ferroelectric memory according to claim 17, wherein the 2ⁿ-1 ferroelectric capacitors (12) are sequentially arranged along a first direction, and
the 2ⁿ-1 first electrode plates (121) form an integrated structure;
the 2ⁿ-1 second electrode plates (122) form an integrated structure and are connected to a same power line (PL), and potentials of the 2ⁿ-1 second electrode plates (122) are the same; and
the 2ⁿ-1 dielectric layers (123) form an integrated structure, and thicknesses of the 2ⁿ-1 dielectric layers (123) are different.

19. The data writing method for a ferroelectric memory according to claim 17, wherein the 2ⁿ-1 ferroelectric capacitors (12) are sequentially arranged along a first direction, and
the 2ⁿ-1 first electrode plates (121) form an integrated structure;
the 2ⁿ-1 dielectric layers (123) form an integrated structure; and
the 2ⁿ-1 second electrode plates (122) are spaced apart from each other and connected to different power lines, respectively, and potentials of the 2ⁿ-1 second electrode plates (122) are different.

20. An electronic apparatus (1), comprising:
a processing device (2); and
a memory device (3) electrically connected to the processing device (2), the memory device (3) comprising the ferroelectric memory according to any one of claims 1 to 13.
